# EUROPÄISCHE PATENTANMELDUNG

(11) **EP 1 612 843 A1**
(43) Veröffentlichungstag der Anmeldung: **04.01.2006**
(21) Anmeldenummer: 04103158.4
(22) Anmeldetag: 02.07.2004
(51) Int. Cl.: H01L 21/00

(54) **Verfahren und Einrichtung fuer die Montage von Halbleiterchips**

(71) Anmelder: Unaxis International Trading Ltd, 6330 Cham (CH)
(72) Erfinder: Vischer, Dieter, 6300, Zug (CH)
(74) Vertreter: Falk, Urs

(57) **Zusammenfassung**

Ein Verfahren für die Montage von Halbleiterchips (5) auf einem Substrat (2), bei dem Substratplätze (21) in Kolonnen (22; 23; 24) angeordnet sind, wobei die auf einer Folie (20) haftenden Halbleiterchips (5) auf einem Wafertisch (4) bereitgestellt werden, wobei die Ablösung eines Halbleiterchips (5) von der Folie (20) mittels eines Chip-Auswerfers (6) unterstützt wird und wobei eine Pick und Place Einrichtung (7) den über dem Chip-Auswerfer (6) bereitgestellten Halbleiterchip (5) aufnimmt und auf dem Substrat (2) absetzt, ist gekennzeichnet durch:
- Vorschub des Substrats (2) entlang einer als x-Richtung bezeichneten Transportrichtung,
- Bestücken einer vorbestimmten Anzahl von Kolonnen (22; 23; 24) mit Halbleiterchips (5) gemäss den Schritten:
   - Verschieben der Pick und Place Einrichtung (7) in eine der zu bestückenden Kolonne entsprechende x-Lage,
   - Verschieben des Chip-Auswerfers (6) in diese x-Lage, und
   - Bestücken der Substratplätze (21) der Kolonne.

## Beschreibung

Die Erfindung betrifft ein Verfahren für die Montage von Halbleiterchips der im Oberbegriff des Anspruchs 1 genannten Art und eine dazu geeignete Einrichtung.

Es sind verschiedene Typen von Montageautomaten für die Montage von Halbleiterchips auf einem Substrat bekannt. Auf der einen Seite des Spektrums findet man die sogenannten Die Bonder, die eingesetzt werden, um Halbleiterchips mit hoher Geschwindigkeit und grosser Genauigkeit auf einem Substrat zu montieren. Solche Die Bonder sind z.B. bekannt aus den Veröffentlichungen EP 923111 und EP 991110, bzw. beschrieben in der europäischen Patentanmeldung Nr. 03101438.4 oder der schweizerischen Patentanmeldung Nr. 2003 1006/03. Die Halbleiterchips werden auf einem Wafertisch bereitgestellt. Die zu bestückenden Substrate werden nacheinander taktweise zugeführt, wobei jeweils ein Substrat auf einem Substrattisch fixiert und für die Bestückung mit Halbleiterchips bereitgestellt wird. Die Montage der Halbleiterchips erfolgt mittels eines von einem Pick und Place System angetriebenen Bondkopfs. Von der Anmelderin vertriebene Die Bonder enthalten ein Pick und Place System mit einer ersten schnellen Achse, die den Transport des Halbleiterchips vom Wafertisch zum Substrat mit grosser Geschwindigkeit ermöglicht, und mit einer orthogonal zur ersten Achse verlaufenden zweiten Achse, die eine Verschiebung des Halbleiterchips im Bereich einiger zehn Mikrometer erlaubt, so dass eine allfällige Abweichung der Ist-Lage von der Soll-Lage korrigiert werden kann. Dieses Konzept ermöglicht eine einfache und günstige Bauweise, schränkt aber den Die Bonder dahingehend ein, dass immer nur ein bestimmter Halbleiterchip auf dem Substrat montiert werden kann. Auf der anderen Seite des Spektrums findet man sogenannte Bestückungsautomaten, die zwei schnelle, orthogonal zueinander verlaufende Achsen aufweisen, die einen grossen Arbeitsbereich abdecken. Der Vorteil dieses Konzeptes ist, dass mehrere verschiedene Halbleitertypen und auch andere Bauteile nacheinander auf dem gleichen Substrat montiert werden können. Der Nachteil ist, dass die Montagezeit viel grösser als bei einem Die Bonder ist.

Beim Die Bonder werden die Substrate von einer Transporteinrichtung taktweise vorgeschoben und bei Substraten mit mehreren, in Kolonnen nebeneinander liegenden Substratplätzen, kolonnenweise abgearbeitet. Das Substrat wird immer dann vorgeschoben, wenn eine Kolonne vollständig mit Halbleiterchips bestückt ist. Es gibt auch Anwendungen, bei denen mehrere Kolonnen zu einem Block zusammengefasst werden. Weil der Vorschub mit der Transporteinrichtung während der Bestückung eines Blocks aus verschiedensten Gründen oftmals unerwünscht ist, sind Die Bonder entwickelt worden, bei denen der Substrattisch mit dem auf dem Substrattisch fixierten Substrat in Transportrichtung verschoben werden kann, so dass die Kolonnen eines Blocks bestückt werden können, ohne dass die Fixierung des Substrats auf dem Substrattisch gelöst werden muss.

Aus der EP 1049140 ist eine Halbleiter-Montageeinrichtung bekannt, bei der die Lage des auf dem Wafertisch bereitgestellten Halbleiterchips vor seiner Aufnahme von einer Kamera vermessen und eine Korrektur einer allfälligen Lageabweichung des Halbleiterchips von seiner Soll-Lage erfolgt, indem die Folie vom Chip-Auswerfer mittels Vakuum festgehalten wird und dann zumindest die der Folie zugewandte obere Fläche des Chip-Auswerfers in der parallel zur Folienunterseite verlaufenden Ebene verschoben wird. Der Bewegungsbereich dieses Chip-Auswerfers ist vergleichsweise klein, da er nur kleine Korrekturbewegungen ermöglichen muss.

Aus der US 6 149 047 ist eine Halbleiter-Montageeinrichtung bekannt, bei der der Wafertisch, die Pick und Place Einrichtung und der Chip-Auswerfer in zwei horizontalen Richtungen verschiebbar sind, damit die Halbleiter-Montageeinrichtung trotz zunehmender Grösse der Wafer auf möglichst kleinem Raum Platz findet. Der Nachteil ist eine deutliche Verlangsamung des Montageprozesses.

Der Erfmdung liegt die Aufgabe zugrunde, einen Die Bonder so zu verbessern, dass mehrere nebeneinander liegende Kolonnen von Substratplätzen abgearbeitet werden können, ohne dass das Substrat nach der Abarbeitung jeder Kolonne vorgeschoben werden muss und ohne dass der Substrattisch in Transportrichtung verschiebbar sein muss.

Die genannte Aufgabe wird erfindungsgemäss gelöst durch die Merkmale der Ansprüche 1 und 2.

Die Erfindung basiert auf der Erkenntnis, dass es zwar grundsätzlich möglich ist, ein Pick und Place System mit zwei schnellen Achsen zu bauen, bei dem beide Achsen einen Arbeitsbereich von mehreren Zentimetern abdecken, dass aber eine solche Konstruktion sehr aufwendig wird, wenn bei der Bestückung eines jeden Halbleiterchips beide Achsen bewegt werden müssen. Die Erfindung schlägt deshalb vor, einerseits das Pick und Place System mit einer parallel zur Transportrichtung der Substrate verlaufenden Achse auszurüsten, die einen Arbeitsbereich von mehreren Zentimetern abdeckt, und andererseits auch den Chip-Auswerfer, der die Ablösung der Halbleiterchips von der Folie unterstützt, mit einer parallel zur Transportrichtung der Substrate verlaufenden, motorisierten Achse auszurüsten, die den gleichen Arbeitsbereich abdeckt. Diese Konstruktion ermöglicht es, nachdem eine Kolonne vollständig mit Halbleiterchips bestückt worden ist und die nächste Kolonne mit Halbleiterchips zu bestücken ist, sowohl das Pick und Place System als auch den Chip-Auswerfer parallel zur Transportrichtung der Substrate zu verschieben, so dass mehrere Kolonnen bestückt werden können, ohne dass das Substrat verschoben werden muss, und dass während der Bestückung der Substratplätze, die zur gleichen Kolonne gehören, der Bondkopf in Transportrichtung der Substrate nur allfällige, im Vergleich zum Abstand zwischen benachbarten Kolonnen kleine Korrekturbewegungen durchführen muss, so dass ein permanentes Hin und Herfahren des Bondkopfs über vergleichsweise grosse Distanzen parallel zur Transportrichtung der Substrate entfällt.

Die Erfindung nimmt mit dieser Lösung eine Vergrösserung der Halbleiter-Montageeinrichtung in Kauf, da das Pick und Place System einen zweidimensionalen Arbeitsbereich aufweist.

Die Erfindung wird nachfolgend anhand eines Ausführungsbeispiels und anhand der Zeichnung näher erläutert.

Es zeigen:
- Fig. 1: schematisch und in Aufsicht eine Halbleiter-Montageeinrichtung,
- Fig. 2-4: verschiedene Momentaufnahmen während der Bestückung eines Substrats mit Halbleiterchips, das in Kolonnen angeordnete Substratplätze aufweist.

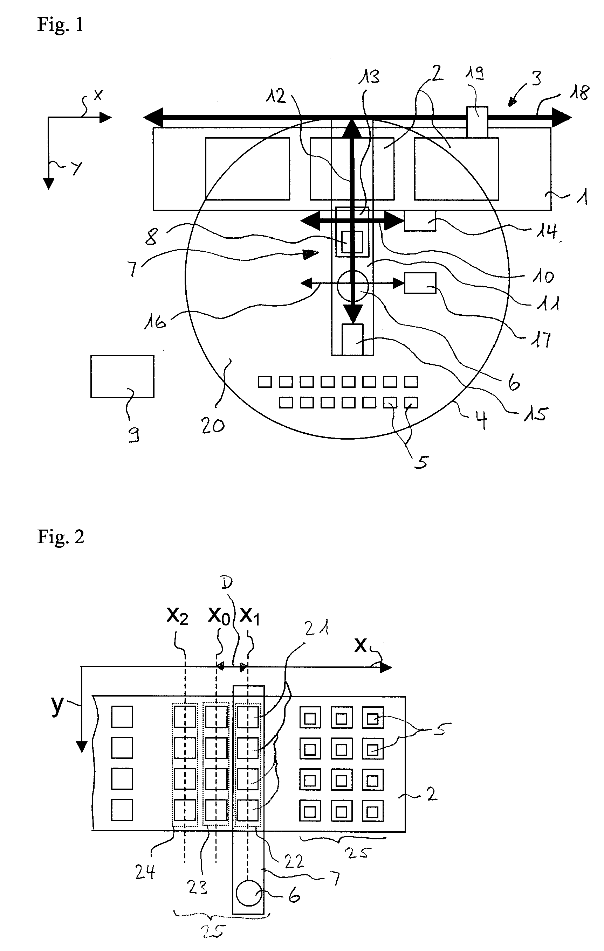

Die Erfindung betrifft eine Halbleiter-Montageeinrichtung, die in der Fachwelt als Die Bonder bekannt ist. Die Fig. 1 zeigt schematisch und in Aufsicht eine solche Halbleiter-Montageeinrichtung. Die Halbleiter-Montageeinrichtung umfasst einen ortsfest angeordneten Substrattisch 1 mit einer Auflagefläche für das Substrat 2, eine Transportvorrichtung 3 für den Transport der Substrate 2 entlang einer vorbestimmten, als x-Richtung bezeichneten Transportrichtung, einen Wafertisch 4 mit den zu montierenden Halbleiterchips 5, einen Chip-Auswerfer 6 für die Unterstützung der Ablösung des als nächster zu montierenden Halbleiterchips 5 vom Wafertisch 4, eine Pick und Place Einrichtung 7 mit einem Bondkopf 8, der den über dem Chip-Auswerfer 6 bereitgestellten Halbleiterchip entnimmt und auf dem Substrat 2 platziert, und eine Steuereinrichtung 9. Die Pick und Place Einrichtung 7 ermöglicht Bewegungen des Bondkopfs 8 entlang von zwei orthogonal zueinander verlaufenden, als x und y bezeichneten Richtungen. Die Pick und Place Einrichtung 7 enthält eine erste, stationär angeordnete Führung 10, auf der ein erster, in x-Richtung hin und her bewegbarer Schlitten 11 gelagert ist. Der erste Schlitten 11 enthält eine zweite Führung 12, auf der ein zweiter, in y-Richtung hin und her bewegbarer Schlitten 13 gelagert ist. Der Bondkopf 8 befindet sich auf dem zweiten Schlitten 13. Die beiden Schlitten 11 und 13 werden von je einem Antrieb 14 bzw. 15 angetrieben. Die beiden Schlitten 11 und 13 ermöglichen also Bewegungen des Bondkopfs 8 in x und y Richtung. Der Chip-Auswerfer 6 ist auf einer dritten Führung 16 gelagert und mittels eines weiteren Antriebs 17 in x-Richtung, d.h. parallel zur Transportrichtung der Substrate 2 verschiebbar. Ausgehend von einer mittleren Position, die als x₀ bezeichnet wird, können sowohl der erste Schlitten 11 als auch der Chip-Auswerfer 6 in x-Richtung innerhalb eines vorgegebenen Arbeitsbereiches [x₀-d, x₀+d] hin und her bewegt werden. Die Distanz d beträgt beispielsweise 40 Millimeter. Die Transportvorrichtung 3 besteht beispielsweise aus einer Führung 18 für die Führung von mindestens einer beweglichen Klammer 19. Die Transportvorrichtung 3 transportiert die Substrate 2 hintereinander zum Bondplatz, wo die Pick und Place Einrichtung 7 den Halbleiterchip jeweils auf einem Substratplatz absetzt. Die vier Führungen 10, 12, 16 und 18 sind in der Figur symbolisch durch Pfeile dargestellt, die den Bewegungsbereich der Schlitten 11 und 13, des Chip-Auswerfers 6, sowie der Klammer 19 illustrieren.

Die Halbleiterchips 5 haften auf einer auf einen Rahmen eingespannten Folie 20 (in der Fachwelt bekannt als blue tape). Der Wafertisch 4 nimmt den Rahmen auf. Bei den Halbleiter-Montageeinrichtungen gemäss dem Stand der Technik ist der Chip-Auswerfer 6 stationär angeordnet. Der Wafertisch 4 ist parallel und orthogonal zur Transportrichtung der Substrate 2, d.h. in x-Richtung und in y-Richtung bewegbar, so dass ein Halbleiterchip 5 nach dem anderen über dem Chip-Auswerfer 6 platziert und dort vom Bondkopf 8 entnommen und auf dem bereitgestellten Substrat 2 montiert werden kann.

Die Steuereinrichtung 9 ist eingerichtet, die Pick und Place Einrichtung 7 und den Chip-Auswerfer 6 synchron parallel zur Transportrichtung des Substrats 2 zu verschieben, damit bei Substraten, bei denen mindestens zwei Substratplätze für die Aufnahme von Halbleiterchips in einer Kolonne nebeneinander angeordnet sind, Kolonne um Kolonne mit Halbleiterchips bestückt werden kann, ohne den Bondkopf 8 ausser für Korrekturbewegungen parallel zur Transportrichtung des Substrats 2 verschieben zu müssen.

Damit die Halbleiterchips 5 mit grosser Genauigkeit lagegenau auf dem Substratplätzen platziert werden können, wird die Lage des über dem Chip-Auswerfer 6 bereitgestellten Halbleiterchips und die Lage des Substratplatzes mit entsprechenden Kameras vermessen und in Bewegungssignale für das Pick und Place System umgesetzt.

Die Fig. 2 bis 4 illustrieren beispielhaft ein solches Verfahren für die Montage der Halbleiterchips auf einem Substrat, bei dem vier Substratplätze 21 für die Aufnahme von Halbleiterchips in einer Kolonne nebeneinander angeordnet sind und bei dem drei hintereinander liegende Kolonnen 22, 23 und 24 einen Block 25 bilden. Die Bestückung der Substratplätze eines solchen Blocks 25 erfolgt gemäss den folgenden Verfahrensschritten:
- Das Substrat 2 wird von der Transportvorrichtung 3 in x-Richtung vorgeschoben, bis die mittlere Kolonne 23 die x-Lage x₀ einnimmt. Die x-Lage der ersten Kolonne 22 ist bezeichnet als x₁, die x-Lage der dritten Kolonne 24 ist bezeichnet als x₂. Die Lagen x₁ und x₂ ergeben sich aus der Lage x₀ entsprechend dem Abstand D zwischen zwei benachbarten Kolonnen des Blocks 25.
- Die Pick und Place Einrichtung 7 wird in die x-Lage x₁ gebracht, in der sich ihre y-Achse zentriert über der ersten Kolonne 22 befindet.
- Der Chip-Auswerfer 6 wird ebenfalls in die x-Lage x₁ gebracht.

Dieser Zustand ist in der Fig. 2 dargestellt.
- Die Substratplätze 21 der ersten Kolonne 22 werden nun nacheinander bestückt, indem
   a) der Wafertisch 4 bewegt wird, um den nächsten Halbleiterchip 5 über dem Chip-Auswerfer 6 bereitzustellen, und
   b) die Pick und Place Einrichtung 7 den über dem Chip-Auswerfer 6 bereitgestellten Halbleiterchip 5 aufnimmt und auf dem zu bestückenden Substratplatz 21 absetzt. Bei diesem Vorgang legt der Bondkopf 8 (Fig. 1) der Pick und Place Einrichtung 7 eine vergleichsweise grosse Distanz in y-Richtung zurück. In x-Richtung führt der Bondkopf 8 jedoch nur eine vergleichsweise kleine Korrekturbewegung Δx aus, um eine allfällige Fehllage des Halbleiterchips zu eliminieren. "Kleine" Korrekturbewegung bedeutet, dass Δx sehr klein im Vergleich zur Distanz D zwischen benachbarten Kolonnen ist.
   Die Schritte a und b werden wiederholt, bis alle Substratplätze 21 der ersten Kolonne 22 bestückt sind.

Als Nächstes wird die mittlere Kolonne 23 mit Halbleiterchips bestückt. Für die Bestückung der zweiten, mittleren Kolonne 23 werden nun
- Die Pick und Place Einrichtung 7 in die x-Lage x₀ gebracht, in der sich ihre y-Achse zentriert über der mittleren Kolonne 23 befindet.
- Der Chip-Auswerfer 6 in die x-Lage x₀ gebracht.

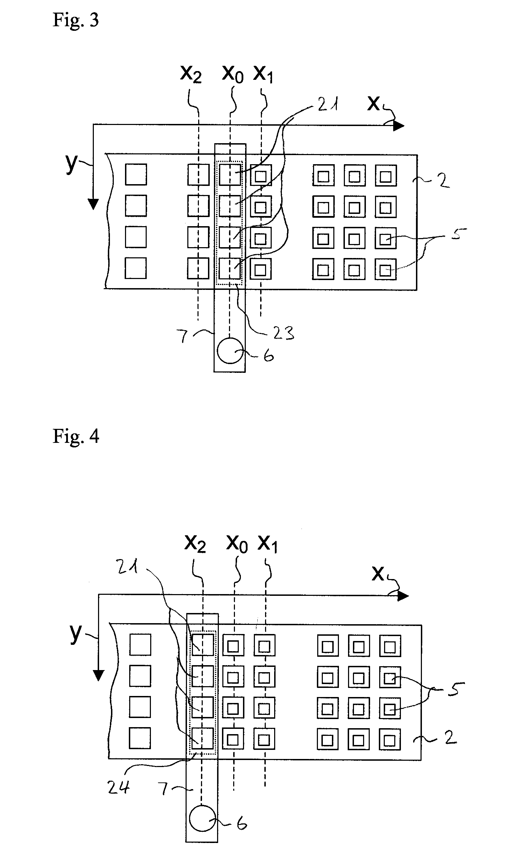

Dieser Zustand ist in der Fig. 3 dargestellt.
- Die Substratplätze 21 der mittleren Kolonne 23 werden nun nacheinander bestückt, indem
   a) der Wafertisch 4 bewegt wird, um den nächsten Halbleiterchip 5 über dem Chip-Auswerfer 6 bereitzustellen, und
   b) die Pick und Place Einrichtung 7 den über dem Chip-Auswerfer 6 bereitgestellten Halbleiterchip 5 aufnimmt und auf dem zu bestückenden Substratplatz absetzt, wobei der Bondkopf 8 in x-Richtung nur eine vergleichsweise kleine Korrekturbewegung ausführt.
   Die Schritte a und b werden wiederholt, bis alle Substratplätze 21 der mittleren Kolonne 23 bestückt sind.

Als Nächstes wird die dritte Kolonne 24 mit Halbleiterchips bestückt. Für die Bestückung der dritten Kolonne 24 werden nun
- Die Pick und Place Einrichtung 7 in die x-Lage x₂ gebracht, in der sich ihre y-Achse zentriert über der dritten Kolonne 24 befindet.
- Der Chip-Auswerfer 6 in die x-Lage x₂ gebracht.

Dieser Zustand ist in der Fig. 4 dargestellt.
- Die Substratplätze 21 der dritten Kolonne 24 werden nun nacheinander bestückt, indem
   a) der Wafertisch 4 bewegt wird, um den nächsten Halbleiterchip 5 über dem Chip-Auswerfer 6 bereitzustellen, und
   b) die Pick und Place Einrichtung 7 den über dem Chip-Auswerfer 6 bereitgestellten Halbleiterchip 5 aufnimmt und auf dem zu bestückenden Substratplatz absetzt, wobei der Bondkopf 8 in x-Richtung nur eine vergleichsweise kleine Korrekturbewegung ausführt.

   Die Schritte a und b werden wiederholt, bis alle Substratplätze 21 der dritten Kolonne 24 bestückt sind.

Alle drei Kolonnen 22, 23 und 24 des gleichen Blocks 25 sind nun bestückt. Für die Bestückung des nächsten Blocks wird nun das Substrat 2 von der Transportvorrichtung 3 entsprechend vorgeschoben, bis die mittlere Kolonne des nächsten Blocks die Lage x₀ einnimmt. Anschliessend werden die drei Kolonnen wie oben beschrieben mit Halbleiterchips 5 bestückt.

## Patentansprüche

1. Verfahren für die Montage von Halbleiterchips (5) auf einem Substrat (2), bei dem mindestens zwei Substratplätze (21) für die Aufnahme von Halbleiterchips (5) in einer Kolonne (22; 23; 24) nebeneinander angeordnet sind, wobei die auf einer Folie (20) haftenden Halbleiterchips (5) auf einem Wafertisch (4) bereitgestellt werden, wobei die Ablösung eines Halbleiterchips (5) von der Folie (20) mittels eines Chip-Auswerfers (6) unterstützt wird und wobei eine Pick und Place Einrichtung (7) den über dem Chip-Auswerfer (6) bereitgestellten Halbleiterchip (5) aufnimmt und auf dem zu bestückenden Substratplatz (21) absetzt, **gekennzeichnet durch** folgende Schritte:
- Vorschub des Substrats (2) entlang einer als x-Richtung bezeichneten Transportrichtung,
- Bestücken einer vorbestimmten Anzahl von Kolonnen (22; 23; 24) mit Halbleiterchips (5) gemäss den Schritten:
- Verschieben der Pick und Place Einrichtung (7) in der Transportrichtung in eine der zu bestückenden Kolonne entsprechende x-Lage,
- Verschieben des Chip-Auswerfers (6) in diese x-Lage,
- Bestücken der Substratplätze (21) der Kolonne mit Halbleiterchips (5), indem
a) der Wafertisch (4) bewegt wird, um den nächsten Halbleiterchip (5) über dem Chip-Auswerfer (6) bereitzustellen, und
b) die Pick und Place Einrichtung (7) den über dem Chip-Auswerfer (6) bereitgestellten Halbleiterchip (5) aufnimmt und auf dem zu bestückenden Substratplatz (21) absetzt,
wobei die Schritte a und b wiederholt werden, bis alle Substratplätze (21) der Kolonne bestückt sind.

2. Halbleiter-Montageeinrichtung, umfassend einen Substrattisch (1) mit einer Auflagefläche für das Substrat (2), eine Transportvorrichtung (3) für den Transport des Substrats (2) entlang einer vorbestimmten Transportrichtung, einen Wafertisch (4) für die Bereitstellung eines Halbleiterchips (5), einen Chip-Auswerfer für die Unterstützung der Ablösung des Halbleiterchips (5) vom Wafertisch (4), eine Pick und Place Einrichtung (7) mit einem Bondkopf (8), der den über dem Chip-Auswerfer (6) bereitgestellten Halbleiterchip (5) entnimmt und auf dem Substrat (2) platziert, wobei die Pick und Place Einrichtung (7) eine erste, stationär angeordnete Führung (10) für die Führung eines ersten Schlittens (11) parallel zur Transportrichtung des Substrats (2) und eine zweite, auf dem ersten Schlitten (11) angeordnete Führung (12) für die Führung eines zweiten Schlittens (13) aufweist, wobei die zweite Führung (12) orthogonal zur ersten Führung (10) verläuft und wobei der Bondkopf (8) auf dem zweiten Schlitten (13) angeordnet ist, und eine Steuereinrichtung (9), **dadurch gekennzeichnet, dass** der Substrattisch (1) ortsfest angeordnet ist, dass der Chip-Auswerfer (6) auf einer dritten, parallel zur Transportrichtung der Substrate (2) verlaufenden Führung (16) verschiebbar gelagert ist und dass die Steuereinrichtung (9) eine Betriebsart aufweist, in der der erste Schlitten (11) der Pick und Place Einrichtung (7) und der Chip-Auswerfer (6) parallel zur Transportrichtung des Substrats (2) verschoben werden, um bei Substraten, bei denen mindestens zwei Substratplätze (21) für die Aufnahme von Halbleiterchips (5) in einer Kolonne (22; 23; 24) nebeneinander angeordnet sind, jede Kolonne mit Halbleiterchips (5) zu bestücken, wobei der erste Schlitten (11) nur im Vergleich zum Abstand zwischen benachbarten Kolonnen kleine Korrekturbewegungen ausführt.
